Europäisches Patentamt

European Patent Office

Office européen des brevets

(11) Publication number: **0 135 179**
**B1**

# EUROPEAN PATENT SPECIFICATION

(45) Date of publication of patent specification: 03.08.88

(51) Int. Cl.⁴: **C 23 C 16/18,** C 23 C 16/48

(21) Application number: 84110261.9

(22) Date of filing: 29.08.84

(54) Process for depositing metallic copper.

(30) Priority: 16.09.83 US 533021

(43) Date of publication of application:
27.03.85 Bulletin 85/13

(45) Publication of the grant of the patent:
03.08.88 Bulletin 88/31

(84) Designated Contracting States:
CH DE FR GB IT LI NL SE

(56) References cited:
EP-A-0 002 738
US-A-3 356 527

APPLIED PHYSICS LETTERS, vol. 38, no. 7,
April 1981, R. SOLANKI ET AL: "Laser photo-
deposition of refractory metals", pp. 572-574
APPLIED PHYSICS LETTERS, vol. 35, no. 2, July
15, 1979, T.F. DEUTSCH et al. "Laser photo-
deposition of metal films with microscopic
features", pp. 175-177

(73) Proprietor: International Business Machines
Corporation
Old Orchard Road
Armonk, N.Y. 10504 (US)

(72) Inventor: Baum, Thomas Hall
201, 2118 Canoas Garden Avenue
San Jose California 95125 (US)
Inventor: Houle, Frances Anne
40635 Ladero Street
Fremont California 94539 (US)
Inventor: Jones, Carol Ruth
5958 Drytown Place
San Jose California 95120 (US)

(74) Representative: Hobbs, Francis John
IBM United Kingdom Limited Intellectual
Property Department Hursley Park
Winchester Hampshire SO21 2JN (GB)

EP 0 135 179 B1

Courier Press, Leamington Spa, England.

## Description

This invention relates to a process for depositing metallic copper on a substrate.

US—A—3,356,527 discloses a process for depositing copper by heating the vapour of a fluorinated copper chelate.

The article in pages 572 to 574 of Applied Physics Letters Volume 38 No. 7 discloses a process for depositing metal at room temperature, or a little above, by the photo-decomposition of a vapourised organic compound, particularly a carbonyl, of the metal. Applications of the process for depositing several different metals are disclosed, but the article does not suggest that copper can be deposited by such a process.

The article in pages 175 to 177 of Applied Physics Letters, Volume 35, No. 2, discloses the laser photodeposition of metals such as aluminium, cadmium and tin from metal alkyl compounds.

The present invention provides a process for depositing a metal on a substrate by photo-decomposing at room temperature a vapourised organic compound of the metal confined in an enclosed chamber containing the substrate, the compound being at ambient vapour pressure, the process being characterised by the metal compound being a photo-decomposable fluorinated organic copper compound, and by the vapourised copper compound being mixed with a gaseous source of hydrogen atoms.

The present invention is particularly useful for producing a patterned deposit of copper, for example in the building of structures in or on a semiconductor or other electrical device, or on a coating.

In the process of the present invention, the vapour of the copper compound, in the gas phase or adsorbed onto the surface of the substrate, absorbs light and undergoes excitation and subsequent chemical reaction to yield copper atoms which deposit on the surface of the substrate. When carrying out the invention, the light can be from a laser and it can also be from incoherent light sources, such as a Hg mercury arc lamp. The irradiation should take place in the presence of another vapour which acts as a source of hydrogen atoms and becomes a co-reductant. The most preferred such material is ethanol. Any alcohol possessing an alpha hydrogen atom could also be used, as could other compounds having a weak carbon to hydrogen bond.

Focused beams, laser or incoherent light can be used, in which case a large area of the substrate can be covered with copper metal. In carrying out selectively patterned deposition, the radiation can be patterned by the use of masks, by focusing devices, and by other procedures known to the prior art. This removes the need for patterning the substrate by lithographic means.

No special apparatus is required for carrying out the process. The substrate is simply placed in an enclosed chamber and the vapour of the fluorinated organic copper compound is introduced. Ethanol vapour, for example, is also introduced. Irradiation is then carried out, and the desired copper deposition results.

The most desirable fluorinated organic copper compound for use in the present invention is bis(1,1,1,5,5,5-hexafluoro-2,4-pentanedionate)-copper (II). The preparation of this compound is described in Inorganic Chemistry, Vol. 5, No. 3, March 1966 by Bertrand and Kaplan. Its name is usually written simply as $Cu(hfac)_2$. Other useful compounds include, for example, fluorinated derivatives of acyl or acetylacetonate copper complexes. Mixtures of materials may also be used.

Preferred substrates include $SiO_2$, alumina, sapphire and silicon, but any of a very large number of materials would be suitable. Such materials include, for example, polymeric coatings and other materials used either as insulators or semiconductors.

Imagewise vapour phase seeding for plating applications is a desirable improvement over present seeding techniques in that present techniques require masking and ultimate removal of the seed in the unplated region, and are all wet processes.

For circuitization, many techniques are available for patterning copper lines, but all require multiple process steps with masking and lithography. Direct patterned deposition, as in the present invention, eliminates the need for such steps.

The copper deposition according to the present invention takes place at a rapid rate, and yields adherent deposits which have good electrical conductivity.

Filling openings in large area films or lines or circuit lines is another application of the present invention. For example, if a copper circuit line 20 μm wide and 2 μm high is found to be defective by having part of its length missing, e.g. 50 μm of length, laser written copper deposition can repair the defect by "writing" from one end of the opening to the other, thus providing a continuous, connecting, conducting, copper line.

Examples of photochemical deposition of copper metal

The air was evacuated from an enclosed chamber containing a quartz substrate. A mixture of $Cu(hfac)_2$ vapour and ethanol vapour was introduced into the chamber and irradiated with a mercury arc lamp. A copper mirror was formed on the quartz substrate by the deposition of metallic copper. All depositions were carried out a room temperature and at ambient $Cu(hfac)_2$ vapour pressure. The ethanol vapour pressure was also ambient.

Copper films are also formed when the mixed vapours are likewise irradiated with pulses from a KrF or ArF excimer laser.

## Claims

1. A process for depositing a metal on substrate at room temperature by photo-decomposing a vapourised, organic compound of the metal confined in an enclosed chamber containing the substrate, the compound being at ambient vapour pressure, the process being characterised by the metal compound being a photo-decomposable fluorinated organic copper compound, and by the vapourised copper compound being mixed with a gaseous source of hydrogen atoms.

2. A process as claimed in claim 1, in which the substrate is subjected to a pattern of light which decomposes the vapourised copper compound so that a corresponding pattern of metallic copper is deposited on the substrate.

3. A process as claimed in claim 1 or claim 2, in which the light is provided by a laser.

4. A process as claimed in any preceding claim, in which the source of hydrogen atoms is ethanol.

5. A process as claimed in any preceding claim, in which the copper compound is Cu(hfac)$_2$.

## Patentansprüche

1. Verfahren zum Abscheiden eines Metalls auf ein Substrat bei Raumtemperatur durch Photoabscheidung aus einer verdampften, organischen Verbindung des Metalls innerhalb einer das Substrat enthaltenden abgeschlossenen Kammer unter Umgebungsdampfdruck, dadurch gekennzeichnet, daß als Metallverbindung eine photoaufspaltbare, fluorierte organische Kupferverbindung vorgesehen wird und daß die verdampfte Kupferverbindung vermischt wird mit einer Gasquelle aus Wasserstoffatomen.

2. Verfahren nach Anspruch 1, dadurch gekennzeichnet, daß das Substrat einem Lichtmuster ausgesetzt wird zum Abscheiden der verdampften Kupferverbinung, so daß ein entsprechendes Muster aus metallischem Kupfer auf dem Substrat niedergeschlagen wird.

3. Verfahren nach Anspruch 1 oder 2, gekennzeichnet durch Verwendung von Laserlicht.

4. Verfahren nach einem der vorhergehenden Ansprüche, gekennzeichnet durch die Verwendung von Äthanol als Quelle von Wasserstoffatomen.

5. Verfahren nach einem der vorhergehenden Ansprüche, gekennzeichnet durch Verwendung von Cu(hfac)$_2$ als Kupferverbindung.

## Revendications

1. Procédé de dépôt d'un métal sur un substrat à température ambiante par photodécomposition d'un composé organique vaporisé du métal confiné dans une chambre close contenant le substrat, le composé étant à la pression de vapeur ambiante, le procédé étant caractérisé en ce que le composé de métal est un composé de cuivre organique fluoré photodécomposable, et en ce que le composé de cuivre vaporisé est mélangé avec une source gazeuse d'atomes d'hydrogène.

2. Procédé selon la revendication 1, dans lequel le substrat est soumis à une configuration de lumière qui décompose le composé de cuivre vaporisé de telle façon qu'une configuration correspondante de cuivre métallique est déposée sur le substrat.

3. Procédé selon l'une des revendications 1 ou 2, dans lequel la lumière est fournie par un laser.

4. Procédé selon l'une quelconque des revendications précédentes, dans lequel la source d'atomes d'hydrogène est l'éthanol.

5. Procédé selon l'une quelconque des revendications précédentes, dans lequel le composé de cuivre est Cu(hfac)$_2$.